# FASCICULE DE BREVET EUROPEEN

(11) **EP 3 375 094 B1**
(45) Date de publication et mention de la délivrance du brevet: **04.12.2019**
(21) Numéro de dépôt: 16791000.9
(22) Date de dépôt: 03.11.2016
(51) Int. Cl.: H03K 17/76, H04B 1/48

(54) **CIRCUIT INTÉGRANT UNE FONCTION LIMITEUR ET UNE FONCTION COMMUTATEUR ET MODULE TRANSMETTEUR/RÉCEPTEUR COMPORTANT UN TEL CIRCUIT**
SCHALTUNG MIT BEGRENZUNGSFÄHIGKEIT UND SCHALTFUNKTION UND SENDE-/EMPFANGSMODUL MIT SOLCH EINER SCHALTUNG
CIRCUIT INCORPORATING A LIMITING FUNCTION AND A SWITCHING FUNCTION AND TRANSCEIVER MODULE COMPRISING SUCH A CIRCUIT

(30) Priorité: 12.11.2015 FR 1502379
(43) Date de publication de la demande: 19.09.2018
(73) Titulaire: Thales, 92400 Courbevoie (FR)
(72) Inventeur: PETIT, Vincent, 78851 Elancourt Cedex (FR); LOUIS, Bruno, 78851 Elancourt Cedex (FR); CORBIERE, Rémi, 78851 Elancourt Cedex (FR); LE BORGNE, Christine, 78851 Elancourt Cedex (FR)
(74) Mandataire: Lavoix
(86) Numéro de dépôt international: PCT/EP2016/076515
(87) Numéro de publication internationale: WO 2017/080898

(56) Documents cités:
- WO-A1-03/092182
- US-A- 5 220 679

## Description

L'invention a pour domaine celui des circuits intégrant une fonction limiteur et une fonction commutateur, notamment des circuits intégrés réunissant ces fonctions sur un même substrat.

L'invention a également pour domaine celui des modules transmetteur/récepteur, ou modules T/R, connectés à chacun des éléments rayonnants d'une antenne composite.

Le document WO03/092182 divulgue un circuit RF de communication sans fil qui comprend une antenne d'émission et de réception, un circuit de modulation, un circuit de commutation et un de circuit démodulation placés en séquence.

Le document US5,220,679 divulgue un diplexeur d'émission-réception ayant un canal de transmission pour transmettre des signaux de transmission radiofréquence sur une antenne qui est connectable à un terminal d'antenne et ayant un canal de réception pour transmettre un signal reçu de l'antenne à un récepteur, au moins une diode étant prévue dans le canal de réception comme commutateur radiofréquence (RF).

La solution couramment utilisée pour réaliser les fonctions limiteur et commutateur d'un module T/R est celle qui consiste à utiliser des composants externes aux circuits intégrés réalisant d'une part la chaîne d'émission, F1, et d'autre part la chaîne de réception, F2.

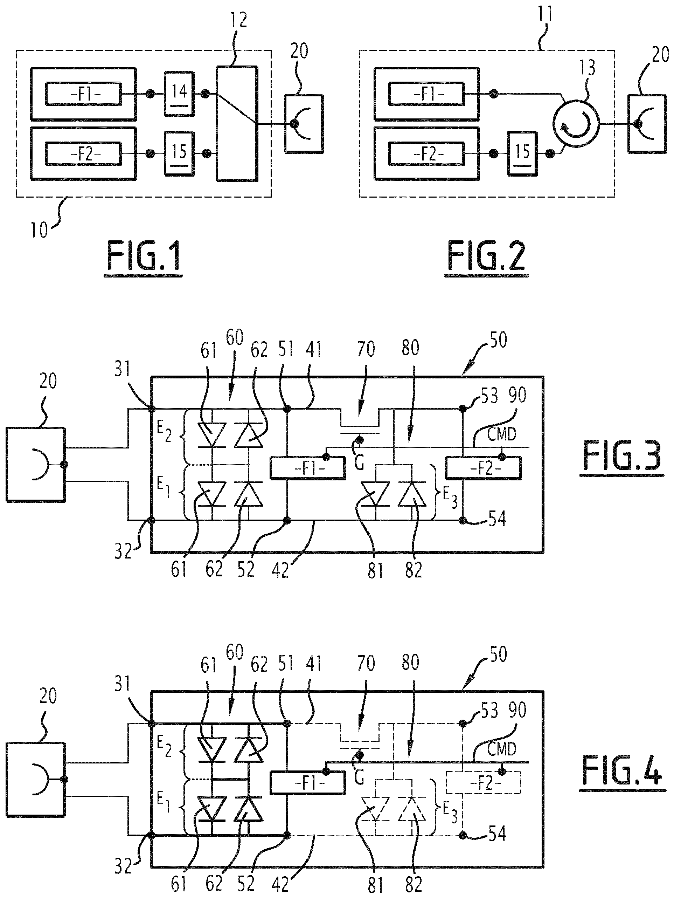

Plus précisément, comme représenté sur le module T/R 10 de la figure 1, des composants externes sont utilisés pour réaliser une fonction commutateur, permettant de connecter à l'élément rayonnant 20 soit la chaine d'émission F1, soit la chaîne de réception F2. Cette fonction commutateur est réalisée en utilisant un interrupteur 12.

Des composants externes sont également utilisés pour réaliser des fonctions de protection de chacune des fonctions F1 et F2 contre des agressions électromagnétiques externes, captées par l'élément rayonnant 20.

Sur la figure 1, un premier limiteur 14 protège la fonction d'émission F1 lorsque celle-ci est connectée, via l'interrupteur 12, à l'élément rayonnant 20, et un second limiteur 15 protège la fonction de réception F2 lorsque celle-ci est connectée, via l'interrupteur 12, à l'élément rayonnant 20.

Sur la figure 2, le module T/R 11 utilise un circulateur 13 pour réaliser la fonction commutateur. Dans ce cas, la fonction de protection de la chaîne d'émission est assurée par le circulateur 13 lui-même, la chaîne de réception étant protégée par un limiteur 15.

Un inconvénient supplémentaire de ces solutions est qu'elles mettent en œuvre des technologies à la fois différentes de celles utilisées pour réaliser les circuits intégrés des chaînes d'émission et de réception, et différentes pour réaliser les fonctions limiteur et les fonctions commutateur.

Ces solutions de l'état de la technique sont par conséquent encombrantes alors qu'il y a un besoin d'intégration des modules T/R au plus près de l'élément rayonnant associé, en particulier dans le volume situé juste à l'arrière de cet élément rayonnant, de manière notamment à limiter les pertes entre l'amplificateur de puissance de la chaîne d'émission et l'élément rayonnant.

L'invention a donc pour but de palier aux inconvénients précités, notamment en proposant un circuit permettant d'intégrer les fonctions de limiteur et de commutateur sur un même substrat, le circuit permettant à deux fonctions, en l'occurrence les fonctions d'émission et de réception, de partager un même accès, en l'occurrence la ligne de connexion à l'élément rayonnant, tout en étant protégées contre les agressions externes.

Pour cela l'invention a pour objet un circuit comportant :
- une première ligne connectée à une première borne de sortie et une seconde ligne connectée à une seconde borne de sortie,
- une première paire de bornes de connexion d'une première fonction entre les première et seconde lignes,
- une seconde paire de bornes de connexion à une seconde fonction entre les première et seconde lignes,
- un dispositif de commutation permettant, dans l'état passant, de connecter la seconde paire de bornes aux première et seconde bornes de sortie, le dispositif de commutation comportant au moins un transistor, fonctionnant en interrupteur intégré dans la première ligne entre une borne de la première paire de bornes et une borne de la seconde paire de bornes,
- une ligne de commande pour appliquer un signal de commande sur une grille dudit au moins un transistor, le signal de commande étant également appliqué à la première fonction de manière à la désactiver lorsque ledit transistor est passant,
- un premier limiteur entre les première et seconde bornes de sortie et la première paire de bornes et un second limiteur entre le dispositif de commutation et la seconde paire de bornes de connexion à la seconde fonction, un premier seuil de limitation en puissance du premier limiteur étant supérieur à un second seuil de limitation en puissance du second limiteur.

L'invention comporte une ou plusieurs des caractéristiques suivantes, prises isolément ou suivant toutes les combinaisons possibles :
- un limiteur parmi les premier et second limiteurs comporte au moins un étage de diodes, ledit étage de diodes étant constitué d'une paire de diodes montées en parallèle et en configuration « tête - bêche », lesdits étages de diodes étant placés en série entre les première et seconde lignes.
- le circuit est un circuit intégré ;
- une jonction permettant de réaliser une diode d'un limiteur où le transistor du dispositif de commutation est réalisée en technologie substrat « bulk » au moyen d'un caisson NWELL ou PWELL ;
- une diode étant réalisée au moyen d'un caisson NWELL ou PWELL délimité dans le substrat du circuit, le substrat est connecté à la masse du circuit et la diode est polarisée au moyen d'un potentiel de mode commun servant de potentiel de référence pour le signal en tension à limiter ;

L'invention a également pour objet un module de transmission / réception, destiné à être connecté à un élément rayonnant et comportant au moins un amplificateur de puissance d'une chaîne d'émission et un amplificateur faible bruit d'une chaîne de réception, caractérisé en ce qu'il comporte un circuit conforme au circuit précédent, l'amplificateur de puissance étant connecté au circuit en tant que première fonction et l'amplificateur faible bruit étant connecté au circuit en tant que seconde fonction ;

De préférence, le circuit étant un circuit intégré, l'amplificateur de puissance et/ou l'amplificateur faible bruit est intégré sur le même substrat que ledit circuit.

L'invention est présentée en détail dans la description qui va suivre, au moyen d'un ou plusieurs modes de réalisation préférentiels, présentés à titre d'exemple non limitatif de l'invention, cette description étant faite en référence aux dessins annexés sur lesquels :
- les figures 1 et 2 représentent, sous forme fonctionnelle, un module T/R dont la fonction commutateur est réalisée soit par un interrupteur, soit par un circulateur ;
- le figure 3 représente un schéma électrique d'un premier mode de réalisation de l'invention ;

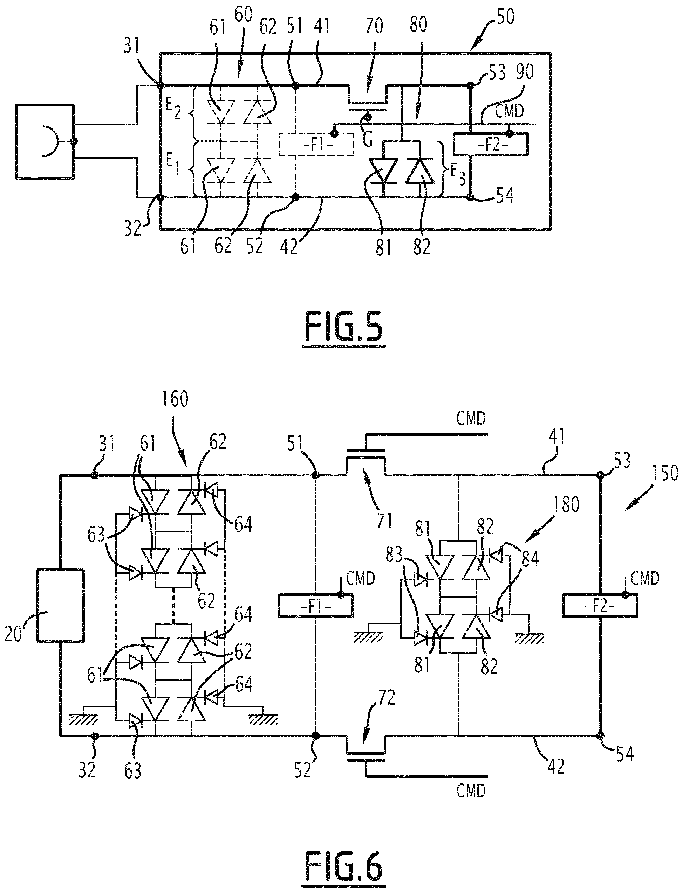

- les figures 4 et 5 représentent deux états de fonctionnement possibles du circuit de la figure 3 ;
- la figure 6 est un schéma électrique d'un second mode de réalisation du circuit selon l'invention ; et,

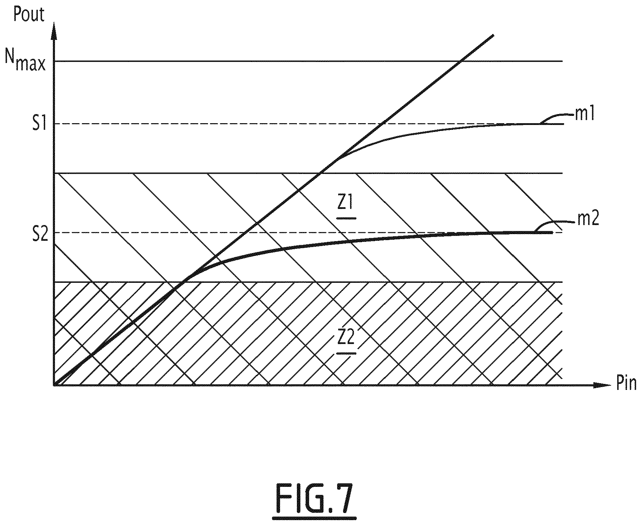

- la figure 7 est un graphe représentant schématiquement la puissance de sortie en fonction de la puissance d'entrée du circuit de la figure 3 en fonction de son état de fonctionnement.

En se référant à la figure 3, le circuit intégré 50 comporte une première paire de bornes 51 et 52, destinées à être connectées aux bornes de sortie d'une chaîne de transmission F1, en tant qu'exemple d'une première fonction.

Le circuit intégré 50 comporte une seconde paire de bornes 53 et 54 destinées à être connectées aux bornes de sortie d'une chaîne de réception F2, en tant qu'exemple d'une seconde fonction.

Le circuit intégré 50 comporte une paire de bornes de sortie 31 et 32 destinées à être connectées à un élément rayonnant 20 d'une antenne composite, en tant qu'exemple d'une ressource dont l'accès doit être partagé entre les première et seconde fonctions F1 et F2.

Le circuit intégré 50 comporte une première ligne 41 et une seconde ligne 42.

La première ligne 41 relie successivement la première borne de sortie 31, la première borne 51 de connexion à la première fonction F1 et la première borne 53 de connexion à la seconde fonction F2.

De manière symétrique, la seconde ligne 42 relie successivement les seconde borne de sortie 32, la seconde borne 52 de connexion à la première fonction F1 et la seconde borne 54 de connexion à la seconde fonction F2.

Entre les bornes 51 et 52 de connexion à la première fonction F1 et les bornes de sortie 31 et 32 vers l'élément rayonnant 20, le circuit intégré 50 comporte un premier limiteur 60 de protection de la première fonction F1.

Le premier limiteur 60 est constitué par deux étages de diodes E1 et E2, montés en série entre les première et seconde lignes 41 et 42. Chaque étage de diodes est constitué d'une paire de diodes 61 et 62 montée en parallèle l'une de l'autre, dans une configuration « tête bêche » l'une par rapport à l'autre.

Entre les bornes 51 et 52 de connexion à la première fonction F1 et les bornes 53 et 54 de connexion à la seconde fonction F2, le circuit intégré 50 comporte un dispositif de commutation. Plus précisément, le dispositif de commutation comporte un interrupteur intégré le long de la première ligne 41. L'interrupteur est constitué d'un transistor 70, MOS ou FET.

Entre le dispositif de commutation et les bornes 53 et 54 de connexion à la seconde fonction F2, le circuit intégré 50 comporte un second limiteur 80 de protection de la seconde fonction F2.

Le second limiteur 80 est constitué d'un étage de diodes E3, comportant deux diodes 81 et 82, montées en parallèle l'une de l'autre et dans une configuration « tête bêche » l'une par rapport à l'autre, entre la première ligne 41 et la seconde ligne 42.

Le circuit intégré 50 comporte une ligne de commande 90 permettant l'application d'un signal de commande CMD binaire sur la grille G du transistor 70.

Le signal de commande CMD est également appliqué à une borne de déclenchement de la première fonction F1 et à une borne de déclenchement de la seconde fonction F2. Ainsi, sur la figure 3, la ligne de commande 90 est représentée schématiquement comme connectée non seulement à la grille G de transistor 70 mais également aux fonctions F1 et F2.

Sur la figure 4, le circuit de la figure 3 est repris dans le cas de l'activation de la première fonction F1. Le signal de commande CMD prenant la valeur 1 (ON), le transistor 70 est ouvert et la première fonction F1 est active. Le transistor 70 étant ouvert la seconde fonction F2 n'a pas accès aux bornes de sorties 31 et 32 vers l'élément rayonnant 20. La seconde fonction F2 est avantageusement désactivée par le signal de commande CMD.

Le premier limiteur 60 permet alors de protéger la première fonction F1 contre les agressions électromagnétiques incidentes sur l'élément rayonnant 20. Le nombre d'étage de diodes du limiteur 60 permet d'ajuster le seuil d'écrêtage en tension du signal correspondant à la différence de potentielle entre les première et seconde lignes 41 et 42. En effet, ce seuil correspond à la somme des seuils d'activation des diodes en série mises en conduction, à savoir les diodes 11 lorsque le signal est positif ou 12 lorsque le signal est négatif, le signal correspondant à la différence entre le potentiel de la première ligne 41 diminué du potentiel de la seconde ligne 42.

Le fait de présenter un seuil d'écrêtage en tension élevé conduit à ce que le premier limiteur présente un seuil d'écrêtage en puissance S1 élevé. Ceci est compatible avec une première fonction F1 du type chaîne d'émission, qui est propre à délivrer un signal utile de puissance élevée. Celui-ci n'est donc pas écrêté par le premier limiteur 60.

A la figure 5, le signal de commande CMD prend la valeur 0 (OFF) de sorte que l'interrupteur 70 est passant, et la première fonction 1 est inactive. La seconde fonction F2 active a alors accès aux bornes de sortie 31 et 32 couplées à l'élément rayonnant 20.

Le second limiteur 80 présente des seuils positif et négatif d'écrêtage en tension réduits par rapport à ceux du premier limiteur 60, du fait d'un nombre plus réduit d'étages de diodes et/ou du choix de diodes présentant un seuil d'activation plus bas.

Par conséquent, la plage de fonctionnement du second limiteur est réduite et incluse dans celle du premier limiteur. Le second limiteur 80 écrête le signal entre les première et seconde lignes 41 et 42 avant que le premier limiteur 60 ne soit actif. C'est donc bien le second limiteur 80 qui protège la seconde fonction F2.

Comme représenté schématiquement sur la figure 7, représentant la puissance de sortie Pout (c'est-à-dire la puissance du signal entre les bornes de sorties 31 et 32) en fonction de la puissance d'entrée Pin soit aux bornes 51 et 52 de la première fonction F1 courbe m1 ou entre les bornes 53 et 54 de la seconde fonction F2 courbe m2.

On voit que le circuit intégré 50 permet de protéger deux fonctions différentes avec des niveaux de protection différents. Le seuil de limitation en puissance S1 définit par le première limiteur 60 définit une zone Z1 de fonctionnement nominale de la première fonction F1 qui est étendue et une protection de cette première fonction à des niveaux d'agression élevé. De manière similaire, le seuil de limitation en puissance S2 du second limiteur 80 est ajusté de manière à être inférieur au premier seuil S1, de manière à définir une zone Z2 de fonctionnement nominale de la seconde fonction F2 qui est plus réduite, afin de protéger la seconde fonction F2 pour des niveaux d'agression plus bas, par exemple des niveaux d'agression se situant dans la zone Z1 de fonctionnement nominale de la première fonction F1. Le passage d'une zone de fonctionnement à l'autre correspond à l'activation du dispositif de commutation de connexion de la seconde fonction F2 et de désactivation de la première fonction F1.

Le circuit selon l'invention permet donc de protéger deux fonctions différentes sans perturber le fonctionnement nominal de chacune de ces fonctions sur une zone de fonctionnement prédéfinie, tout en assurant la commutation entre ces zones de fonctionnement.

Dans le présent circuit intégré 50, la seconde fonction F2 est secondaire par rapport à la première fonction F1, qui est principale. Ceci à cause du dispositif de commutation série réalisé par le transistor 70 en amont duquel se trouve la première fonction F1 et en aval duquel se trouve la seconde fonction F2 (les qualificatifs d'amont et d'aval étant définis par rapport aux bornes de sortie 31 et 32).

La fonction de commutation est donc réalisée non seulement par le transistor 70 mais également par le fait d'appliquer un signal de commande CMD à la première fonction F1 pour la désactivée lorsque la seconde fonction 2 accède à la ressource à partager.

Le temps de commutation est très faible, de l'ordre de la nanoseconde, ce qui le circuit compatible des fonctions d'émission et de réception des applications radars et de guerre électroniques.

L'ordre des fonctions du circuit intégré 50 est favorable aux fonctions de commutation et de limitation d'un module T/R. En effet, dans le cas d'un module T/R, on cherche à protéger la fonction de réception à un niveau plus bas que la fonction d'émission. La fonction de réception connectée au circuit 50 en tant que seconde fonction F2 est alors effectivement protégée par une double protection en amont et en aval du transistor 70 par les premier et second limiteurs 60 et 80. De plus, la fonction d'émission connectée au circuit 50 en tant que première fonction F1, en amont du transistor 70, est protégée par le premier limiteur 60.

De plus, et de manière particulièrement avantageuse, la fonction d'émission n'est pas perturbée par la fonction de commutation, et ceci contrairement à l'état de l'art dans lequel la fonction de commutation se situe sur le chemin du signal de puissance entre la chaîne d'émission et l'élément rayonnant. En conséquence, avec le circuit selon l'invention, le signal de puissance généré par la chaîne d'émission est appliqué directement à l'élément rayonnant. Le circuit selon l'invention permet donc d'améliorer le rendement d'un module T/R.

Si les pertes sur le signal de puissance sont réduites, cela diminue d'autant la dissipation thermique qui constitue une limite sur la puissance maximale admissible par un circuit intégré. Puisque la dissipation thermique est ici réduite, la puissance maximale admissible est augmentée. Le module T/R utilisant le circuit intégré 50 présente dont une puissance maximale admissible accrue par rapport à l'état de la technique.

Par ailleurs, l'homme du métier constatera que le circuit 50 est facilement intégrable. En effet, il n'utilise que des diodes et des transistors. Or de tels composants actifs peuvent être fabriqués avec des jonctions réalisables quelle que soit la technologie utilisée pour réaliser le circuit intégré correspondant. Le circuit 50 peut donc être facilement intégré sur un substrat.

De manière particulièrement avantageuse, il peut être intégré sur le même substrat que la première et/ou la seconde fonction. Dans le cas d'un module T/R, le circuit 50 peut être intégré sur le même substrat que l'amplificateur de puissance constituant l'étage de sortie de la chaîne d'émission et/ou l'amplificateur faible bruit de l'étage d'entrée de la chaîne de réception.

Ainsi, le circuit selon l'invention présente toutes les caractéristiques requises à une intégration compatible d'un module T/R de puissance en particulier hyperfréquence. L'invention permet la suppression des commutateurs et limiteurs externes et l'intégration sur un même substrat des différentes fonctions. Le module T/R présente donc un encombrement réduit permettant de le loger à l'arrière et au plus proche de l'élément rayonnant correspondant.

La figure 6 représente un second mode de réalisation du circuit selon l'invention.

Dans le circuit 150, le dispositif de commutation comporte un premier transistor 71 formant interrupteur, intégré dans la première ligne 41 et un second transistor 72 formant interrupteur intégré dans la seconde ligne 42. Les premier et second transistors 71 et 72 sont commandés de manière totalement synchrone par l'application d'un même signal de commande CMD, qui est également appliqué à la première fonction F1 pour l'activer ou la désactiver.

Dans le circuit 150, le premier limiteur 160 est constitué par l'empilement de N étage de diodes montés en série entre les première et seconde lignes 41 et 42. Chaque étage de diodes est constitué par une paire de diodes en parallèle, en configuration tête bêche. Le nombre N d'étage est choisi de manière à ajuster le premier seuil de limitation en puissance S1 au-delà duquel le signal correspondant à la différence de potentiel entre les première et seconde lignes est écrêté.

Le second limiteur 180 est ici constitué en deux étages de diodes montés en série entre les première et seconde lignes 41 et 42, chaque étage de diode étant constitué par une paire de diode montée en parallèle et en configuration tête bêche.

La technologie utilisée pour fabriquer les diodes des limiteurs du circuit intégré 50 ou 150 est de préférence une technologie du type substrat « bulk » (pour lesquels les jonctions sont réalisées dans la masse du substrat), notamment du type silicium/substrat « bulk » (pour lesquels le substrat est constitué de Silicium).

Plus précisément, le substrat en silicium est dopée de manière à présenter un excès de porteurs de charge P. Un premier volume du substrat, dénommé caisson, situé à l'aplomb des bornes formant respectivement la cathode et l'anode de la diode à fabriquer, est dopé de manière à présenter un excès de porteurs de type N. Puis, à l'intérieur de ce caisson du type NWELL, un second volume, situé à l'aplomb de l'anode de la diode à fabriquée, est dopé de manière à présenter un excès de porteurs de charge de type P.

De manière similaire, une diode peut être fabriquée au moyen d'un caisson du type PWELL délimité dans un substrat dopée de manière à présenter un excès de porteurs de charge N.

Cependant, si une diode est effectivement réalisée à l'intérieur du caisson, une diode parasite est présente à l'interface entre le substrat et le caisson.

Sur la figure 6, ces diodes parasites sont représentées, chaque diode parasite étant associée à la diode réalisée dans le caisson correspondant : diodes parasites 63 et 64 pour les diodes 61 et 62 du premier limiteur 160 et 83 et 84 pour les diodes parasites associées aux diodes 81 et 82 du second limiteur 180.

Pour éviter que la diode parasite, dont le seuil d'activation est relativement faible par rapport à celui d'une ou plusieurs diodes en série, ne limite le seuil de limitation en puissance S1 ou S2 du premier ou du second limiteur, 160, 180, il est avantageux de polariser le substrat du circuit intégré 150 à la masse et de polariser les diodes en connectant la seconde ligne 42 à un potentiel de mode commun VMC et la première ligne 41 à un potentiel correspondant au potentiel de mode commun VMC augmenté du signal en tension à limiter S.

En fixant la valeur du potentiel de mode commun VMC de manière adéquate, notamment en fonction du seuil en tension d'activation des diodes parasites, la plage de fonctionnement nominale en tension du limiteur 160 ou 180, définie entre un seuil négatif d'écrêtage en tension et un seuil positif d'écrêtage en tension, est translatée vers les tensions positives pour éviter l'activation de la diode parasite 62 ou 84. La sélection de la valeur du potentiel de mode commun VMC permet également d'élargie la plage de fonctionnement nominale en tension du limiteur 160 ou 180, en tenant compte du seuil d'activation de la diode parasite et de la tension maximale que peut supporter le circuit intégré, tension maximale caractéristique de la technologie mise en œuvre.

En variante, puisque le circuit intégré est totalement symétrique, il est utilisé en différentiel : la seconde ligne 42 est portée au potentiel de référence VMC diminué de la moitié du signal en tension à limiter S et la première ligne 41 est portée au potentiel de référence VMC augmenté de la moitié du signal en tension à limiter S. Cette variante est particulièrement avantageuse, car le signal de puissance délivré par l'amplificateur de puissance d'une chaîne d'émission sur substrat « bulk » est un signal la plupart du temps différentiel, de par la structure même de l'amplificateur.

## Revendications

1. Circuit (50 ; 150) comportant :
- une première ligne (41), connectée à une première borne de sortie (31) et une seconde ligne (42) connectée à une seconde borne de sortie (32) ;
- une première paire de bornes (51, 52) de connexion d'une première fonction (F1) entre les première et seconde lignes ;
- une seconde paire de bornes (53, 54) de connexion à une seconde fonction (F2) entre les première et seconde lignes ;
- un dispositif de commutation connectant, dans l'état passant, la seconde paire de bornes aux première et seconde bornes de sortie, le dispositif de commutation comportant au moins un transistor (70 ; 71, 72), fonctionnant en interrupteur intégré dans la première ligne (41) entre une borne de la première paire de bornes et une borne de la seconde paire de bornes ;
- une ligne de commande pour appliquer un signal de commande (CMD) sur une grille dudit au moins un transistor, le signal de commande étant également appliqué à la première fonction (F1) de manière à la désactiver lorsque ledit transistor est passant,
- un premier limiteur (60 ; 160) entre les première et seconde bornes de sortie et la première paire de bornes et un second limiteur (80 ; 180) entre le dispositif de commutation et la seconde paire de bornes, un premier seuil de limitation en puissance (S1) du premier limiteur étant supérieur à un second seuil de limitation en puissance (S2) du second limiteur.

2. Circuit selon la revendication 1, dans lequel un limiteur parmi les premier et second limiteurs (60, 80 ; 160 ; 180) comporte au moins un étage de diodes, ledit étage de diodes étant constitué d'une paire de diodes (61, 62 ; 81, 82) montées en parallèle et en configuration « tête bêche », lesdits étages de diodes étant placés en série entre les première et seconde lignes (41, 42).

3. Circuit selon la revendication 2, dans lequel le circuit est un circuit intégré.

4. Circuit selon la revendication 3, une jonction permettant de réaliser une diode d'un limiteur (60, 80 ; 160 ; 180) où le transistor (70 ; 71, 72) du dispositif de commutation est réalisée en technologie substrat « bulk » au moyen d'un caisson NWELL ou PWELL.

5. Circuit selon la revendication 4, dans lequel une diode étant réalisée au moyen d'un caisson NWELL ou PWELL délimité dans le substrat dudit circuit, le substrat est connecté à la masse dudit circuit et la diode est polarisée au moyen d'un potentiel de mode commun (VMC) servant de potentiel de référence pour le signal en tension à limiter (S).

6. Module de transmission / réception, destiné à être connecté à un élément rayonnant et comportant au moins un amplificateur de puissance d'une chaîne d'émission et un amplificateur faible bruit d'une chaîne de réception, **caractérisé en ce qu'**il comporte un circuit (50 ; 150) selon l'une quelconque des revendications 1 à 5, l'amplificateur de puissance étant connecté au circuit en tant que première fonction (F1) et l'amplificateur faible bruit étant connecté au circuit en tant que seconde fonction (F2).

7. Module selon la revendication 6, dans lequel, le circuit étant un circuit intégré, l'amplificateur de puissance et/ou l'amplificateur faible bruit est intégré sur le même substrat que ledit circuit.

## Patentansprüche

1. Schaltung (50; 150) umfassend:
- eine erste Leitung (41), die an einen ersten Ausgangsanschluss (31) angeschlossen ist, und eine zweite Leitung (42), die an einen zweiten Ausgangsanschluss (32) angeschlossen ist;
- ein erstes Paar von Anschlüssen (51, 52) zwischen der ersten und zweiten Leitung zur Verbindung einer ersten Funktion (F1);
- ein zweites Paar von Anschlüssen (53, 54) zwischen der ersten und zweiten Leitung zur Verbindung einer zweiten Funktion (F2);
- eine Schaltvorrichtung, die im Durchgangszustand das zweite Anschlusspaar mit dem ersten und zweiten Ausgangsanschluss verbindet, wobei die Schaltvorrichtung mindestens einen Transistor (70; 71, 72) aufweist, der als ein in die erste Leitung (41) zwischen einem Anschluss des ersten Anschlusspaars und einem Anschluss des zweiten Anschlusspaars integrierter Unterbrecher arbeitet;
- eine Steuerleitung zum Anlegen eines Steuersignals (CMD) an das Gate des mindestens einen Transistors, wobei das Steuersignal gleichfalls auf die erste Funktion (F1) aufgebracht wird, derart dass sie deaktiviert wird, wenn der Transistor durchgeschaltet ist,
- einen ersten Begrenzer (60; 160) zwischen dem ersten und zweiten Ausgangsanschluss und dem ersten Anschlusspaar und einen zweiten Begrenzer (80; 180) zwischen der Schaltvorrichtung und dem zweiten Anschlusspaar, wobei eine erste Schwelle zur Leistungsbegrenzung (S1) des ersten Begrenzers größer ist als eine zweite Schwelle zur Leistungsbegrenzung (S2) des zweiten Begrenzers.

2. Schaltung nach Anspruch 1, bei der ein Begrenzer von dem ersten und zweiten Begrenzer (60, 80; 160; 180) mindestens eine Diodenstufe aufweist, wobei die Diodenstufe von einem Paar von Dioden (61, 62; 81, 82) gebildet wird, die parallel und entgegengesetzt geschaltet sind, wobei die Diodenstufen in Reihe zwischen der ersten und zweiten Leitung (41, 42) liegen.

3. Schaltung nach Anspruch 2, bei der die Schaltung eine integrierte Schaltung ist.

4. Schaltung nach Anspruch 3, wobei eine Verbindungstelle ermöglicht, eine Diode eines Begrenzers (60, 80; 160; 180) zu realisieren, bei der der Transistor (70; 71, 72) der Schaltvorrichtung mittels einer NWELL oder PWELL Wanne in der Bulk-Substrat-Technologie hergestellt ist.

5. Schaltung nach Anspruch 4, bei der eine Diode mittels einer NWELL oder PWELL Wanne, abgegrenzt in dem Substrat der Schaltung, hergestellt ist, wobei das Substrat an die Masse der Schaltung angeschlossen ist und die Diode mittels eines Common-Mode-Potentials (VMC) polarisiert ist, das als Referenzpotential für das zu begrenzende Spannungssignal (S) dient.

6. Sende/Empfangsmodul, das vorgesehen ist, mit einem abstrahlenden Element verbunden zu werden und das mindestens einen Leistungsverstärker einer Sendekette und einen rauscharmen Verstärker einer Empfangskette aufweist, **dadurch gekennzeichnet, dass** es eine Schaltung (50; 150) nach einem beliebigen der Ansprüche 1 bis 5 aufweist, wobei der Leistungsverstärker als erste Funktion (F1) mit der Schaltung verbunden ist und der rauscharme Verstärker als zweite Funktion (F2) mit dem Schaltkreis verbunden ist.

7. Modul nach Anspruch 6, bei dem, wenn die Schaltung eine integrierte Schaltung ist, der Leistungsverstärker und/oder der rauscharme Verstärker auf demselben Substrat wie die Schaltung integriert sind.

## Claims

1. Circuit (50; 150) comprising:
- a first line (41), connected to a first output terminal (31) and a second line (42) connected to a second output terminal (32);
- a first pair of terminals (51, 52) for connection of a first function (F1) between the first and second lines;
- a second pair of terminals (53, 54) for connection to a second function (F2) between the first and second lines;
- a commutation device connecting, in the conducting state, the second pair of terminals to the first and second output terminals, the commutation device comprising at least one transistor (70; 71, 72) which functions as interrupter integrated in the first line (41) between a terminal of the first pair of terminals and a terminal of the second pair of terminals;
- a control line for applying a control signal (CMD) on a gate of said at least one transistor, the control signal being likewise applied to the first function (F1) in order to deactivate it when said transistor is conducting,
- a first limiter (60; 160) between the first and second output terminals and the first pair of terminals and a second limiter (80; 180) between the commutation device and the second pair of terminals, a first power limitation threshold (S1) of the first limiter being greater than a second power limitation threshold (S2) of the second limiter.

2. Circuit according to claim 1, in which a limiter among the first and second limiters (60, 80; 160; 180) comprises at least one level of diodes, said level of diodes being formed from a pair of diodes (61, 62; 81, 82) which are mounted in parallel and in a "head-to-tail" configuration, said levels of diodes being placed in series between the first and second lines (41, 42).

3. Circuit according to claim 2, in which the circuit is an integrated circuit.

4. Circuit according to claim 3, a junction making it possible to produce a diode of a limiter (60, 80; 160; 180) where the transistor (70; 71, 72) of the commutation device is produced in "bulk" substrate technology by means of an NWELL or PWELL box.

5. Circuit according to claim 4, in which a diode being produced by means of an NWELL or PWELL box delimited in the substrate of said circuit, the substrate is connected to the earth of said circuit and the diode is polarised by means of a common mode potential (VMC) serving as reference potential for the voltage signal to be limited (S).

6. Transmission/reception module, intended to be connected to a radiating element and comprising at least one power amplifier for a transmission chain and a low-noise amplifier for a reception chain, **characterised in that** it comprises a circuit (50; 150) according to any of the claims 1 to 5, the power amplifier being connected to the circuit as first function (F1) and the low-noise amplifier being connected to the circuit as second function (F2).

7. Module according to claim 6, in which, the circuit being an integrated circuit, the power amplifier and/or the low-noise amplifier is integrated on the same substrate as said circuit.
